# NEUE EUROPÄISCHE PATENTSCHRIFT

(11) **EP 1 416 636 B2**
(45) Veröffentlichungstag und Bekanntmachung des Hinweises auf die Entscheidung über den Einspruch: **21.05.2014**
(45) Hinweis auf die Patenterteilung: 27.06.2007
(21) Anmeldenummer: 03022329.1
(22) Anmeldetag: 04.10.2003
(51) Int. Cl.: H03K 17/96

(54) **Sensorelement-Vorrichtung für einen kapazitiven Berührungsschalter mit einem elektrisch leitfähigen Körper und Verfahren zur Herstellung eines solchen Körpers**
Sensor element for a capacitive touch switch with an electrically conductive element and method of producing the same
Elément capteur pour un commutateur capacitif à effleurement avec un élément électriquement conducteur et sa méthode de fabrication

(30) Priorität: 31.10.2002 DE 10251639
(43) Veröffentlichungstag der Anmeldung: 06.05.2004
(73) Patentinhaber: E.G.O. Elektro-Gerätebau GmbH, 75038 Oberderdingen (DE)
(72) Erfinder: Winkler, Uwe, 76275 Ettlingen (DE); Schilling, Wilfried, 76703 Kraichtal (DE)
(74) Vertreter: Patentanwälte Ruff, Wilhelm, Beier, Dauster & Partner

(56) Entgegenhaltungen:
- EP-A- 0 859 467
- EP-A- 1 061 608
- US-A- 4 380 007
- US-A- 5 973 417
- US-B1- 6 265 682

## Beschreibung

Die Erfindung betrifft eine Sensorelement-Vorrichtung gemäß dem Oberbegriff des Anspruchs 1.

Derartige Sensorelement-Vorrichtungen sind beispielsweise aus der EP 859 467 B1 bekannt. Dort wird ein Sensorelement mit einem Körper beschrieben, der in etwa länglich und zylindrisch oder fassförmig ausgebildet ist. Wie aus diesem Stand der Technik ersichtlich ist, werden für nebeneinander angeordnete Sensorelemente beziehungsweise von diesen gebildete Berührungsschalter mehrere solcher Körper benötigt, welche auf einer Leiterplatte angeordnet sind. Als Herstellungsverfahren wird beschrieben, wie derartige Körper von einem Montageautomaten von einer langen Stange abgelängt werden.

Die US 6,265,682 beschreibt eine Sensorelement-Vorrichtung für einen kapazitiven Berührungsschalter mit einem einzigen länglichen, stiftartigen, elastischen und elektrisch leitfähigen Körper. Der Körper ist durchgängig elektrisch leitfähig und gleich sowie homogen.

Die EP 1 061 608 A beschreibt einen Körper aus leitfähigem Elastomer. Dieser Körper dient zur direkten elektrischen Kontaktierung verschiedener Kontaktfelder. Auch er ist durchgängig elektrisch leitfähig und homogen.

### Aufgabe und Lösung

Der Erfindung liegt die Aufgabe zugrunde, eine eingangsgenannte Sensorelement-Vorrichtung zu schaffen, bei denen zum einen der Körper als Sensorelement neuartig ausgebildet ist und erweiterte Funktionalität aufweist.

Gelöst wird diese Aufgabe durch eine Sensorelement-Vorrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß weist die Sensorelement-Vorrichtung einen raumformveränderlichen und elastisch kompressiblen Körper auf, der das Sensorelement bildet. Er ist elektrisch leitfähig und erstreckt sich zumindest in einem Bereich von einer elektrischen Kontaktierung einerseits zu einer Sensorelement-Oberfläche andererseits. Dabei weist er erfindungsgemäß verschiedene Bereiche auf. Einerseits ist dies mindestens ein leitfähiger Bereich, welcher sich zwischen einer elektrischen Kontaktierung und einer Sensorelement-Oberfläche erstreckt und durchgängig elektrisch leitfähig ist. Des weiteren ist mindestens ein isolierender Bereich vorgesehen, der nicht elektrisch leitfähig ist. Zwischen mehreren leitfähigen Bereichen befindet sich mindestens ein isolierender Bereich. So können vorteilhaft leitfähige Bereiche und isolierende Bereiche abwechselnd nebeneinander angeordnet sein. So ist es möglich, gemäß der Erfindung einen einzigen und einheitlichen Körper zu schaffen, der als eine einzige und gut handhabbarere Baueinheit mehrere Sensorelemente und somit mehrere Berührungsschalter bildet.

Vorteilhaft ist die Sensorelement-Oberfläche von der Oberfläche eines Teils eines leitfähigen Bereichs gebildet. Dabei kann die Sensorelement-Oberfläche von der Berühr- bzw. Kontaktfläche zwischen einem Teil eines leitfähigen Bereichs und einer Abdeckung, an der die Sensorelement-Vorrichtung anliegt, gebildet sein. So kann auf eine separate Oberfläche verzichtet werden um den Herstellungsaufwand zu senken. Dieses Prinzip ist aus der EP 859 467 B1 bekannt, auf die diesbezüglich ausdrücklich verwiesen wird.

Ein weiterer Vorteil liegt hierbei darin, dass nicht nur eine Vielzahl kleiner Körper durch einen einzigen und größeren Körper ersetzt wird. Es kann des weiteren Montagevorgänge stark vereinfachen, da nicht mehr viele Teile gehandhabt und eventuell eingesetzt oder aufgesetzt werden müssen, sondern nur noch ein einziges Teil.

Des weiteren ist, vor allem im Vergleich mit der vorgenannten EP 859 467 B1, erkennbar, dass die einzelnen Sensorelement-Körper, wie sie bisher eingesetzt worden sind, umständlich zu handhaben sind aufgrund ihrer teilweise geringen Größe. Ein größerer Körper gemäß der Erfindung dagegen ist leichter handhabbar.

Die mehreren leitfähigen Bereiche und der wenigstens eine isolierende Bereich sind einteilig, mechanisch und fest miteinander verbunden. Vorteilhaft sind sie derart miteinander verbunden, dass sie sozusagen unlösbar sind, also nicht von sich aus auseinander gehen sondern nur durch Krafteinwirkung.

Die Bereiche sind vorteilhaft zwischen der elektrischen Kontaktierung und der Sensorelement-Oberfläche länglich und weisen eine Erstreckungsrichtung in diese Richtung auf. In dieser Erstreckungsrichtung verlaufen vorteilhaft sämtliche leitfähigen Bereiche, also besonders vorteilhaft parallel zueinander. Es ist möglich, auch die isolierenden Bereiche in dieser Erstreckungsrichtung verlaufen zu lassen. Es ist besonders vorteilhaft, wenn die Bereiche zylinderförmig sind mit rundem oder eckigen Querschnitt.

Der Körper besteht vorteilhaft aus einem gummiartigen Material, um die elastischen und kompressiblen Eigenschaften aufzuweisen. Dies kann beispielsweise ein Schaumstoff sein, wobei mittels Ruß oder Metalleinlagerungen die elektrische Leitfähigkeit erzielt wird. Für genauere Ausführungen dieses Sensorelement-Körpers, insbesondere hinsichtlich Herstellung, Materialeigenschaften oder Zusammensetzung, wird auf die EP 859 467 B1 sowie die US-PS 5,087,825 verwiesen.

Der Körper kann Teil eines Strangs sein, also eine sehr große Länge aufweisen. Die vorgenannte Erstreckungsrichtung der Bereiche kann dabei senkrecht zu der Längsrichtung des Strangs verlaufen. Dies bedeutet, dass der Strang so ausgebildet ist, dass er eine große Anzahl nebeneinander angeordneter leitfähiger und isolierender Bereiche aufweist.

Der vorgenannte Strang kann in einem Grundzustand beispielsweise nach der Herstellung geradlinig sein. Dies bezieht sich besonders vorteilhaft auf seine Längsrichtung, so dass es ein gerader Strang ist. Gemäß einer vorteilhaften Ausbildung kann er in einer Richtung quer zur Erstreckungsrichtung der Bereiche biegbar sein, insbesondere elastisch biegbar sein. Dies weist den Vorteil auf, dass beispielsweise bogenförmig angeordnete Sensorelemente gebildet werden können mit einem einzigen Körper. Dazu wird lediglich der Körper in gewünschter Art und Weise gebogen, was durch die Elastizität leicht möglich ist. Bei seiner Befestigung an einer Leiterplatte oder dergleichen oder hinter einer Bedienblende oder dergleichen kann die gebogene Form fixiert werden. So sind z.B. auch kreisförmige Anordnungen möglich.

Alternativ zu einem solchen verbiegbaren Strang kann der Körper bereits in an sich beliebig vorgebbarer Form ausgebildet sein, also auch zickzackförmig oder in Formen, die durch Biegen kaum herstellbar sind. Diese Form kann besonders vorteilhaft durch Herstellen, insbesondere Aneinanderfügen der einzelnen Bereiche, erzielt werden.

Die Abstände von Bereichen zueinander, insbesondere deren gesamte Abmessungen wie Querschnitt und Länge, sind zumindest bei einigen leitfähigen Bereichen gleich. Besonders vorteilhaft sind alle leitfähigen Bereiche gleich ausgebildet. Dies hat vor allem fertigungstechnische Vorteile derart, dass aus einem langen Stangenmaterial beispielsweise die leitfähigen Bereiche abgetrennt werden können und zusammen mit isolierenden Bereichen, welche beispielsweise auf gleiche Art und Weise hergestellt werden, zu einem strangartigen Sensorelement zusammengefügt werden können.

Die Bereiche können zusätzlich zu einer länglichen strangartigen Ausbildung einen Körper bilden, der feldartig oder flächig ausgebildet ist. Somit können verschiedene Bereiche, insbesondere leitfähige und isolierende Bereiche abwechselnd, in beiden flächigen Ausdehnungen des Körpers und miteinander verbunden sein. Dabei ist besonders vorteilhaft vorgesehen, dass wiederum die leitfähigen Bereiche in jeder Richtung voneinander getrennt sind durch isolierende Bereiche. Der so entstehende Körper kann entweder eine geschlossene Fläche bilden oder Ausnehmungen bzw. Durchbrüche aufweisen. Somit ist es möglich, dass sich in der direkten Verbindung zwischen zwei zueinander nächstgelegenen leitfähigen Bereichen, welche jeweils Sensorelemente bilden, entweder ein isolierender Bereich oder eine isolierende Luftstrecke befindet. Der Körper kann derart ausgebildet sein, dass er zugeschnitten werden kann, beispielsweise mit Klingen oder aber mit einem Laser. Alternativ oder zusätzlich kann vorgesehen sein, dass an einer Verbindungsstelle zweier Bereiche der Körper getrennt werden kann. Dies kann beispielsweise durch Abziehen oder Abreißen von Hand und ohne Hilfsmittel erfolgen. Dabei kann die Verbindung der Bereiche, welche beispielsweise eine Klebung sein kann, aufgetrennt werden ohne die einzelnen Bereiche selber zu beschädigen.

Die elektrische Kontaktierung für die leitfähigen Bereiche weist vorteilhaft Kontakte auf, welche besonders vorteilhaft flächenförmig und als Kontaktfelder ausgebildet sein können. Dabei ist vorteilhaft vorgesehen, dass die Kontakte mindestens den Abstand zweier leitfähiger Bereiche zueinander aufweisen oder sogar einen noch größeren. In besonders bevorzugter Ausgestaltung kann vorgesehen sein, dass zwischen zwei zueinander nächstgelegenen Kontakten mehrere, also beispielsweise drei oder vier, leitfähige Bereiche vorgesehen sind. Somit werden direkt nur diejenigen Bereiche kontaktiert, welche an den Kontakten anliegen. Die dazwischen liegenden leitfähigen Bereiche weisen keinen direkten Kontakt auf.

Es kann vorgesehen sein, dass ein isolierender Bereich zwischen leitfähigen Bereichen ein Dielektrikum bildet derart, dass sich zwischen den leitfähigen Bereichen Querkapazitäten und somit kapazitive elektrische Verbindungen ausbilden. Auf diese Art und Weise kann eine elektrische Verbindung auch zu leitfähigen Bereichen erfolgen, welche nicht direkt mit einem Kontakt verbunden sind. Dies kann es möglich machen, weniger Kontaktierungen zu benötigen als leitfähige Bereiche und somit Sensorelement-Oberflächen vorhanden sind. Über die vorgenannten Querkapazitäten können auch diese Sensorelement-Oberflächen ausgewertet werden. Dazu ist eine Auswerteschaltung entsprechend auszulegen, welche mit der Sensorelement-Vorrichtung verbunden ist und die Kontaktierungen aufweist. Möglich ist dies aufgrund der Tatsache, dass die Querkapazitäten bekannt sind. Somit kann von einem aus einer Berührung stammenden Signal an einem der leitfähigen Bereiche über die bekannten Querkapazitäten ermittelt werden, an welcher Stelle die Berührung stattgefunden hat und somit welches bestimmte Signal ausgelöst werden soll.

Erfindungsgemäß weist der gesamte Körper an der zu der elektrischen Kontaktierung gerichteten Seite eine isolierende Schicht oder dergleichen auf. Dies macht es möglich, dass die elektrische Kontaktierung längliche und hochragende Kontaktstifte aufweist. Diese stoßen beim Aufsetzen des Körpers durch die isolierende Schicht hindurch in den leitfähigen Bereich und stellen so die elektrische Kontaktierung her. Dies kann es ermöglichen, ganze strangförmige oder plattenartige Körper auf eine Leiterplatte genau positioniert aufsetzen. Die Leiterplatte kann Kontaktstifte tragen, welche an genau vorbestimmten Stellen durch die isolierende Schicht hindurchstechen und eine gewünschte Kontaktierung zu einzelnen leitfähigen Bereichen herstellen. Andere offenliegende Kontakte oder Lötstellen an der Leitplatte stellen keine ungewünschte Kontaktierung her und verhindern so eine Fehlfunktion.

Ein leitfähiger Bereich ist vorteilhaft von einem oder mehreren isolierenden Bereichen benachbart ummantelt. Vorteilhaft ist er völlig von isolierenden Bereichen umgeben.

Bei dem Verfahren zur Herstellung eines Sensorelement-Körpers werden leitfähige Bereiche gebildet, beispielsweise nach der vorgenannten Art. Sie bestehen aus elektrisch leitfähigem raumformveränderlichem und elastisch kompressiblen Material. Diese leitfähigen Bereiche werden durch isolierende Bereiche verbunden, welche, wie auch zuvor beschrieben worden ist, aus raumformveränderlichen, elastisch kompressiblen und isolierendem Material bestehen. So können derartige Bereiche beispielsweise als zylinderartige Stifte oder dergleichen nebeneinander gereiht werden. Eine Verbindung kann durch Kleben erfolgen, worunter hier in erster Linie eine materialverbindende Verbindung zu verstehen ist. Beispielsweise kann es thermisches Schmelzkleben oder thermisches Schweißen sein.

Es können erheblich mehr leitfähige und isolierende Bereiche nebeneinander als Körper hergestellt werden in Strangform, als tatsächlich für eine Sensorelement-Vorrichtung benötigt wird. Durch Abtrennen einzelner Körper erfolgt dann die Konfektionierung, wie sie tatsächlich benötigt wird.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibungen der Zeichnungen

Ausführungsbeispiele der Erfindungen sind in den Zeichnungen schematisch dargestellt und werden im folgenden näher erläutert. In den Zeichnungen zeigen:
- Figur 1.: Eine prinzipielle Darstellung der Anordnungsmöglichkeiten von leitfähigen und isolierenden Bereichen nebeneinander,
- Figuren 2-4: Ausbildungen von strangartigen Sensorelement-Körpern in gerader oder gebogener Form, bei denen die elektrisch leitfähigen Bereiche von isolierenden Bereichen umgeben sind,
- Figur 5: eine Ausgangsform zur Herstellung eines Sensorelements-Körpers in flächiger Form, aus dem einzelne Sensorelement-Körper durch Quer- und Längsschneiden hergestellt werden und
- Figur 6: eine Darstellung eines Sensorelement-Körpers im Querschnitt , bei dem sich zwischen den elektrischen Kontaktierungen mehrere leitfähige Bereiche befinden.

### Detaillierte Beschreibung der Ausführungsbeispiele

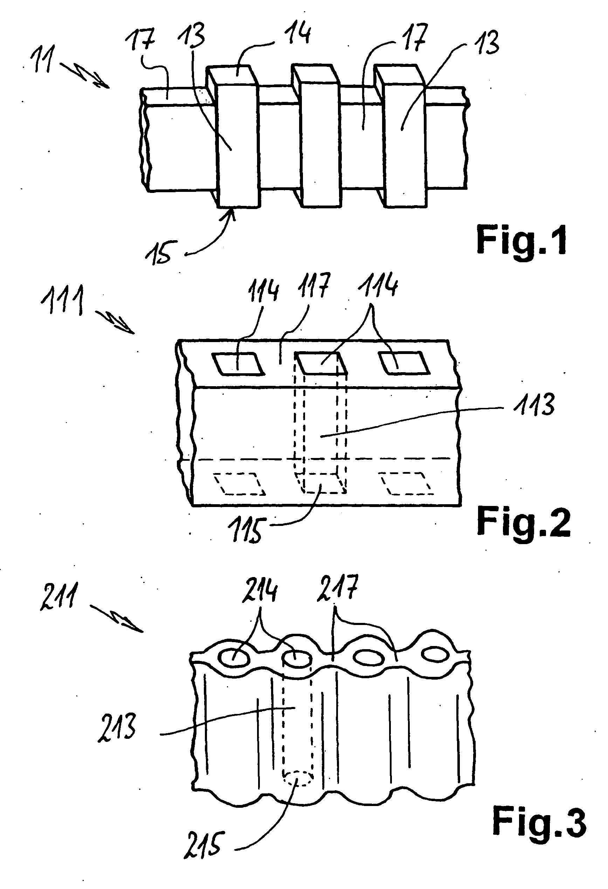

Figur 1 zeigt eine strangförmige Sensorelement-Vorrichtung 11 bzw. einen Abschnitt davon. Die Sensorelement-Vorrichtung 11 besteht aus länglichen, viereckig zylindrischen leitfähigen Bereichen 13. Diese weisen an dem einen Ende eine Sensorelement-Oberfläche 14 auf, in Figur 1 nach oben. An der nach unten weisenden Fläche ist eine elektrische Kontaktfläche vorgesehen. Mit dieser kann eine elektrische Kontaktierung an eine Schaltung oder dergleichen erfolgen. In dieser Form entspricht der leitfähige Bereich 13 in etwa einem elastischen Sensorelement, wie es eingangs genannt worden ist. Dies gilt insbesondere auch für die Funktion der Sensorelement-Oberfläche 14 sowie der elektrischen Kontaktfläche 15.

Die Sensorelement-Vorrichtung 11 weist mehrere dieser leitfähigen Bereiche 13 auf, die in dem dargestellten Ausführungsbeispiel im wesentlichen identisch sind und parallel zueinander verlaufen. Sie sind durch isolierende Bereiche 17 verbunden. Dabei befindet sich jeweils zwischen zwei leitfähigen Bereichen 13 ein isolierender Bereich 17. So wird eine Art Aneinanderreihung der Bereiche 13 und 17 erreicht. Vor allem wird durch die gegebene mechanische Verbindung, welche die Sensorelement-Vorrichtung 11 als eine einzige Baueinheit herstellt, erreicht, dass sie leicht handhabbar und einbaubar ist.

Wie zuvor ausgeführt worden ist, können zur Bildung einer solchen Sensorelement-Vorrichtung 11 die Bereiche 13 und 17 separat hergestellt und anschließend miteinander verbunden werden. Alternativ wäre eine Art Zwischenschäumen möglich. Dabei können entweder die leitfähigen Bereiche 13 oder aber die isolierenden Bereiche 17 zwischen die vorgesehenen Bereiche der anderen Art eingespritzt werden, entsprechend einem in der Kunststoffverarbeitung bekannten Zwei-Komponenten-Spritzen.

Schließlich besteht die Möglichkeit, aus einem einzigen und an sich homogenen Stück Ausgangsmaterial durch Bearbeitung einzelner Bereiche diese entweder im nachhinein elektrisch leitfähig oder aber elektrisch isolierend zu machen. Möglichkeiten hierzu wären beispielsweise thermische oder chemische Bearbeitung oder aber Bestrahlung.

Wie aus Figur 1 zu erkennen ist und auch allgemein zu beachten ist, ist es von Vorteil, wenn die Sensorelement-Oberfläche 14 und/oder die elektrischen Kontaktflächen 15 sämtlich in einer Ebene liegen. Dies vereinfacht zum einen die Herstellung als standardisiertes Strangmaterial. Zum anderen kann ein Einsatz so besser vorgesehen werden. Unter Umständen ist es alternativ auch von Vorteil, verschiedene Längen der leitfähigen Bereiche 13 oder der isolierenden Bereiche 17 vorzusehen.

In Figur 2 ist eine Variation einer Sensorelement-Vorrichtung 111 dargestellt. Auch diese weist leitfähige, zylindrisch langgestreckte Bereiche 113 auf. Sie sind in Figur 2 nach oben mit einer Sensorelement-Oberfläche 114 und nach unten mit einer elektrischen Kontaktfläche 115 versehen.

In Abweichung von der Ausbildung aus Figur 1 sind hier die leitfähigen Bereiche 113 bis auf die Flächen, in denen die Sensorelement-Oberflächen 14 und die elektrischen Kontaktflächen 115 liegen, mit Material 117 umgeben. Dieses Material 117 bildet die isolierenden Bereiche 117. Es befindet sich nicht nur zwischen zwei leitfähigen Bereichen 113, sondern auch noch an deren Seiten. So kann zum einen eine ungewollte seitliche Kontaktierung der leitfähigen Bereiche 113 vermieden werden. Des weiteren wird durch die größere Breite der strangförmigen Sensorelement-Vorrichtung 111 eine unter Umständen einfachere Montage erzielt. Schließlich können unter Umständen Abschirmungen oder dergleichen auf diese Art und Weise hergestellt werden, beispielsweise als zusätzliche Schicht ganz außen an den Seiten des isolierenden Materials 117.

In Figur 3 wiederum ist eine strangförmige Sensorelement-Vorrichtung 211 dargestellt, welche in etwa derjenigen aus Figur 2 entspricht. Hier sind ebenfalls leitfähige Bereiche 213 seitlich völlig mit isolierendem Material umgeben. Dieses bildet die isolierenden Bereiche 217, welche sich unter anderem zwischen jeweils zwei leitfähigen Bereichen 213 befinden.

Entsprechend der Ausbildung aus Figur 2 sind die Sensorelement-Oberflächen 214 und die elektrischen Kontaktflächen 215 frei. Sollte dieses Freibleiben der Flächen 214 und 215 in vorzugsweise einer Ebene jeweils herstellungstechnisch schwierig und nicht exakt zu bewerkstelligen sein, kann einfache Abhilfe geschaffen werden. Diese besteht vorteilhaft darin, dass eine Sensorelement-Vorrichtung plangeschnitten wird um gleiche und plane Oberflächen 214 und 215 zu schaffen, über welche das isolierende Material zumindest nicht übersteht.

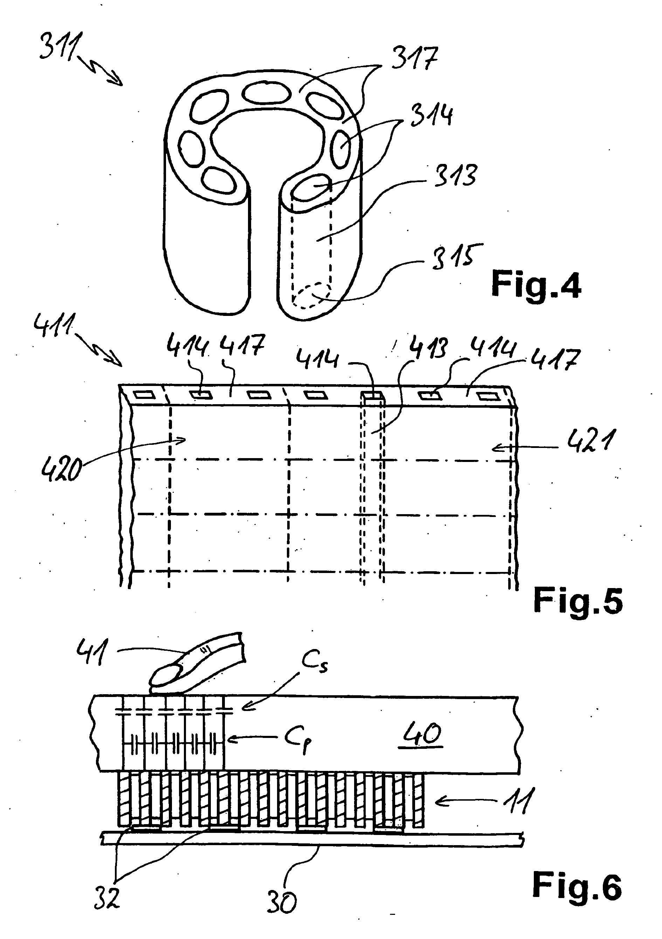

In Figur 4 wiederum ist eine weitere Ausbildung einer Sensorelement-Vorrichtung 311 in Strangform dargestellt, welche in etwa derjenigen aus Figur 2 spricht. Diese ist kreisförmig gebogen und mit ihren Enden beinahe aneinanderstoßend ausgebildet. Eine solche Sensorelement-Vorrichtung 311 kann entweder durch entsprechendes Formen eines geraden Strangmaterials entsprechend Figur 2 hergestellt werden. Alternativ kann die gebogene Form selbsterhaltend ausgebildet sein. Dies ermöglicht eine einfachere Montage.

Die leitfähigen Bereiche 313 und somit auch die Sensorelement-Oberfläche 314 und die elektrische Kontaktfläche 315 sind hier längsoval ausgebildet. Dies spielt jedoch keine Rolle und ist im wesentlichen auch variabel.

Des weiteren kann von der in den Figuren dargestellten länglichen und/oder zylindrischen Form der leitfähigen Bereiche oder der isolierenden Bereiche abgewichen werden. Beispielsweise könnten die Oberflächen 14 und 15 größer gestaltet werden als der Rest der leitfähigen Bereiche als Querschnitt aufweist. Alternativ könnten die Flächen kleiner sein als die Querschnitte. Dies hängt davon ab, welche Flächen bezüglich der Sensorelement-Empfindlichkeit oder -auslösung einerseits und welche Querschnitte bezüglich der elektrischen Leitfähigkeit oder sonstiger elektrischer Eigenschaften andererseits gewünscht sind.

Es ist leicht vorstellbar, dass die Sensorelement-Vorrichtung 311 aus Figur 4 auch geschlossen ausgebildet sein könnte nach Art eines Kreisrings, also die vordere Lücke geschlossen sein kann. Dies liegt im Bereich für den Fachmann aus Figur 4 leicht herleitbaren und ohne weiteres technisch machbaren.

In Figur 5 ist eine Sensorelement-Vorrichtung, 411 dargestellt, welche nach Art einer Platte ausgebildet ist. Parallel zur Ausdehnungsfläche der Vorrichtung verlaufen leitfähige Bereiche 413 mit Sensorelement-Oberflächen 414 und elektrischen Kontaktflächen 415. Ähnlich wie in Figur 2 sind hier auch vollständig umgebende Isolierungen in Form des isolierenden Materials 417 vorgesehen.

Die plattenförmige Sensorelement-Vorrichtung 411 nach Figur 5 kann nun durch Schneiden in längliche und strangförmige Sensorelement-Vorrichtungen entsprechend Figur 2 geteilt werden. Dazu kann entsprechend der strichpunktierten Linien geschnitten oder getrennt werden. Diese strichpunktierten Linien verlaufen senkrecht zur Längserstreckung der leitfähigen Bereiche 413. Die so erhaltenen strangförmigen Sensorelement-Vorrichtungen können dann wiederum entsprechend der strichlierten Linien abgelängt werden. Das in Figur 5 gezeigte Ausführungsbeispiel sieht eine Aufteilung in Zweier- und Viererblöcke vor; also mit jeweils zwei oder vier leitfähigen Bereichen 413.

Eine Ausbildung einer Sensorelement-Vorrichtung 411 nach Figur 5 weist den großen Vorteil, dass sie im wesentlichen automatisch oder sogar vollautomatisch aus Kunststoffverarbeitungsanlagen hergestellt werden kann. Durch entsprechendes Schneiden, Trennen oder Dimensionieren können die gewünschten einzelnen Sensorelement-Vorrichtungen hergestellt werden.

In Figur 6 ist gemäß einem Ausführungsbeispiel dargestellt, wie eine Sensorelement-Vorrichtung 11 entsprechend derjenigen aus Figur 1 eingesetzt werden kann. Eine Leiterplatte 30 trägt, neben nicht dargestellter Elektronik und weiteren Bauteilen, Kontaktfelder 32. Die Kontaktfelder 32 können beispielsweise aus Leiterbahnen aufgebaut sein.

Die Leiterplatte 30 verläuft parallel und mit einem bestimmten Abstand zu einer Unterseite einer Glaskeramikplatte 40. Dazwischen ist die Sensorelement-Vorrichtung 11 angeordnet derart, dass sie mit den elektrischen Kontaktflächen 15 zum Teil an Kontaktfeldern 32 zu liegen kommt. Die Sensorelement-Oberflächen 14 wiederum liegen an der Unterseite der Glaskeramikplatte 40 an. Es ist zu beachten, dass zwischen einzelnen Kontaktfeldern 32 einzelne leitfähige Bereiche 13 auch bezüglich deren Kontaktflächen 15 sozusagen in der Luft hängen können. Somit erfolgt hier keine elektrische Kontaktierung.

Wie in Figur 6 dargestellt, werden über die Glaskeramikplatte 40 als Dielektrikum serielle Kapazitäten Cₛ zur Oberseite hin aufgebaut. Berührt nun ein Finger 41 die Oberseite der Glaskeramikplatte 40 oberhalb eines leitfähigen Bereichs 13 bzw. seiner Sensorelement-Oberfläche 14, so entsteht eine an sich bekannte kapazitive Kopplung. Diese kann über eine entsprechende Auswerteschaltung, welche hier nicht näher beschrieben wird, ausgewertet werden als Betätigung.

Des weiteren sind in Figur 6 jedoch neben den seriellen Kapazitäten Cₛ, welche jeweils oberhalb eines leitfähigen Bereichs 13 gebildet sind, parallele Kapazitäten Cₚ vorhanden. Diese bestehen jeweils zwischen zwei benachbarten leitfähigen Bereichen 13. Sie werden gebildet durch die elektrische Eigenschaften der isolierenden Bereiche 17, die sich zwischen den elektrisch leitfähigen Bereichen 13 befinden. Mittels dieser parallelen Kapazitäten Cₚ erfolgt auch ein elektrischer Anschluss von leitfähigen Bereichen 13, welche nicht direkt über ihre elektrische Kontaktfläche 15 kontaktiert werden. Somit ist es an sich möglich, die Anzahl der Kontaktfelder 32 zu verringern oder jedenfalls geringer anzusetzen als die Anzahl der leitfähigen Bereiche 13. Eine Lokalisierung des Auflegens eines Fingers kann durch die Auswertung der bekannten entsprechenden Querkapazitäten Cₚ erfolgen. Dies ist dann lediglich eine Frage der Auswerteschaltung.

Mit einer solchen Vorrichtung ist es beispielsweise mit vertretbarem Aufwand möglich, entlang einer Linie oder Geraden mehrere Sensorelement-Oberflächen 14 vorzusehen, welche beispielsweise einer Skala oder Abstufung entsprechen. Der Kontaktierungsaufwand kann entsprechend verringert werden.

## Patentansprüche

1. Sensorelement-Vorrichtung (11) für einen kapazitiven Berührungsschalter, wobei die Sensorelement-Vorrichtung einen raumformveränderlichen und elastischen kompressiblen Körper (11, 111, 211, 311, 411) aufweist, der zumindest bereichsweise elektrisch leitfähig ist und sich von einer elektrischen Kontaktierung (15) zu einer Sensorelement-Oberfläche (14) erstreckt, wobei der Körper verschiedene Bereiche aufweist, wobei ein leitfähiger Bereich (13) durchgängig elektrisch leitfähig ist zwischen der elektrischen Kontaktierung (15) und der Sensorelement-Oberfläche (14), wobei ein isolierender Bereich (17) nicht elektrisch leitfähig ist und wobei sich zwischen mehreren leitfähigen Bereichen (13) wenigstens ein isolierender Bereich (17) befindet, wobei die leitfähigen Bereiche (13) und der wenigstens eine isolierende Bereich (17) einteilig miteinander verbunden sind, **dadurch gekennzeichnet, dass** der Körper (11) an der zu der elektrischen Kontaktierung (32) gerichteten Seite mit einer isolierenden Schicht versehen ist, wobei die elektrische Kontaktierung längliche und hochragende Kontaktstifte aufweist, die durch die isolierende Schicht in den leitfähigen Bereich stoßen zur Herstellung der elektrischen Kontaktierung.

2. Sensorelement-Vorrichtung nach Anspruch 1, **dadurch gekennzeichnet, dass** die Sensorelement-Oberfläche (14) gebildet ist durch die Oberfläche eines Teils eines leitfähigen Bereichs (13), wobei die Sensorelement-Oberfläche gebildet ist von der Berührfläche zwischen einem Teil eines leitfähigen Bereichs und einer Abdeckung (40), an der die Sensorelement-Vorrichtung (11) anliegt.

3. Sensorelement-Vorrichtung nach einem der vorhergehenden Ansprüche, **dadurch gekennzeichnet, dass** in der Erstreckungsrichtung von der elektrischen Kontaktierung (15) zu der Sensorelement-Oberfläche (14) zumindest die leitfähigen Bereiche (13) in etwa in derselben Richtung verlaufen, vorzugsweise parallel, wobei insbesondere auch die isolierenden Bereiche (17) in diese Richtung verlaufen und die Bereiche zylinderförmig sind.

4. Sensorelement-Vorrichtung nach einem der vorhergehenden Ansprüche, **dadurch gekennzeichnet, dass** die Bereiche (13, 17) in dieser Erstreckungsrichtung gesehen länglich sind, wobei sie vorzugsweise eine längere Ausdehnung in der Erstreckungsrichtung als in einer anderen Richtung quer dazu aufweisen.

5. Sensorelement-Vorrichtung nach einem der vorhergehenden Ansprüche, **dadurch gekennzeichnet, dass** der Körper (11) aus einem gummiartigen Material besteht, welches insbesondere mit Einlagerungen leitfähig gemacht ist.

6. Sensorelement-Vorrichtung nach einem der vorhergehenden Ansprüche, **dadurch gekennzeichnet, dass** der Körper (11) Teil eines Strangs ist, wobei die Erstreckungsrichtung der Bereiche (13, 17) senkrecht zu der Längsrichtung des Strangs ist, wobei insbesondere der Strang im Grundzustand, vorzugsweise in der Längsrichtung, geradlinig ist, wobei er in einer Richtung quer zur Erstreckungsrichtung der Bereiche biegbar ist.

7. Sensorelement-Vorrichtung nach einem der vorhergehenden Ansprüche, **dadurch gekennzeichnet, dass** die Bereiche einen feldartigen, senkrecht zu der Erstreckungsrichtung flächig ausgedehnten Körper bilden, wobei leitfähige (13) und isolierende (17) Bereiche in beiden Ausdehnungen des Körpers abwechselnd angeordnet sind und vorzugsweise die leitfähigen Bereiche (13) in jeder Richtung voneinander getrennt sind.

8. Sensorelement-Vorrichtung nach Anspruch 7, **dadurch gekennzeichnet, dass** sich in der direkten Verbindung zwischen zwei zueinander nächstgelegenen leitfähigen Bereichen (13) ein isolierender Bereich (17) oder eine Luftstrecke befinden.

9. Sensorelement-Vorrichtung nach einem der vorhergehenden Ansprüche, **gekennzeichnet durch** eine Zuschneidbarkeit des Körpers oder eine Trennbarkeit an den Verbindungsstellen zweier Bereiche, vorzugsweise eine Trennbarkeit **durch** manuelles Abziehen oder Abreißen ohne Hilfsmittel.

10. Sensorelement-Vorrichtung nach einem der vorhergehenden Ansprüche, **dadurch gekennzeichnet, dass** die elektrische Kontaktierung Kontakte (32) aufweist, wobei insbesondere die Kontakte (32) mindestens den Abstand zweier leitfähiger Bereiche (13) zueinander aufweisen, und vorzugsweise mehrere leitfähige Bereiche (13) zwischen zwei zueinander nächstgelegenen Kontakten (32) vorgesehen sind.

11. Sensorelement-Vorrichtung nach einem der vorhergehenden Ansprüche, **dadurch gekennzeichnet, dass** ein isolierender Bereich (17) ein Dielektrikum bildet zwischen zwei leitfähigen Bereichen (13) derart, dass Querkapazitäten (Cₚ) bzw. kapazitive Verbindungen zwischen den leitfähigen Bereichen gebildet sind.

12. Sensorelement-Vorrichtung nach einem der vorhergehenden Ansprüche, **dadurch gekennzeichnet, dass** ein leitfähiger Bereich (13) vollständig von einem oder mehreren isolierenden Bereichen (17) in seitlicher Richtung quer zu seiner Erstreckungsrichtung ummantelt ist.

## Claims

1. Sensor element device (11) for a capacitive contact switch, in which said sensor element device has a three-dimensional shape-variable and elastic, compressible body (11, 111, 211, 311, 411), said body being at least zonally electrically conductive and extending from an electrical contact zone (15) to a sensor element surface (14), said body having different areas, with a conductive area (13) being electrically conductive throughout between said electrical contact zone (15) and said sensor element surface (14), an insulating area (17) not being electrically conductive, and at least one insulating area (17) being located between several of said conductive areas (13), said conductive areas (13) and the at least one insulating area (17) being interconnected in one piece,
**characterized in that**
the body (11) is provided on a side directed towards said electrical contact zone (32) with an insulating coating, said electrical contact zone having elongated and upwardly projecting contact pins pushing through said insulating coating into said conductive area in order to produce said electrical contact.

2. Sensor element device according to claim 1, **characterized in that** the sensor element surface (14) is formed by a surface of part of a conductive area (13), the sensor element surface being formed by the contact area between part of a conductive area and a cover (40), engaging the sensor element device (11).

3. Sensor element device according to any of the preceding claims, **characterized in that** in an extension direction from said electrical contact zone (15) to said sensor element surface (14) at least the conductive areas (13) run in roughly the same direction, preferably in parallel, in particular the insulating areas (17) as well run in said same direction, and the areas are cylindrical.

4. Sensor element device according to any of the preceding claims, **characterized in that** the areas (13, 17) in said extension direction are elongated, and preferably have a longer extension in said extension direction than in another direction traverse thereto.

5. Sensor element device according to any of the preceding claims, **characterized in that** said body (11) is made from a rubbery material that is rendered conductive, in particular by inclusions.

6. Sensor element device according to any of the preceding claims, **characterized in that** said body (11) is part of a strand, an extension direction of said areas (13, 17) being perpendicular to a longitudinal direction of said strand, in particular said strand in a basic state, preferably in the longitudinal direction being linear, and bendable in a direction traverse to the extension direction of said areas.

7. Sensor element device according to any of the preceding claims, **characterized in that** said areas form a bank-like body extended in areal manner perpendicular to the extension direction, said conductive (13) and said insulating (17) areas being arranged in alternating manner in both extensions of said body, and preferably said conductive areas (13) are separated from one another in each direction.

8. Sensor element device according to claim 7, **characterized in that** in a direct connection between two mutually closest of said conductive areas (13) is provided an insulating area (17) or an air gap.

9. Sensor element device according to any of the preceding claims, **characterized in that** said body is cuttable or separable at junction points of two said areas, preferably separable by manual pulling or tearing off without a tool.

10. Sensor element device according to any of the preceding claims, **characterized in that** said electrical contact zone has contacts (32), in particular said contacts (32) at least have a mutual spacing of two said conductive areas (13), and preferably several conductive areas (13) are provided between two mutually closest contacts (32).

11. Sensor element device according to any of the preceding claims, **characterized in that** an insulating area (17) forms a dielectric between two of said conductive areas (13) in such a way that transverse capacitances (Cₚ) or capacitive connections are formed between said conductive areas.

12. Sensor element device according to any of the preceding claims, **characterized in that** a conductive area (13) is completely enveloped by one or more insulating areas (17) in a lateral direction transverse to its extension direction.

## Revendications

1. Dispositif d'élément détecteur (11) pour un commutateur capacitif à effleurement, sachant que le dispositif d'élément détecteur présente un corps (11, 111, 211, 311, 411) élastique et compressible dont la forme tridimensionelle peut varier, qui est électriquement conductible au moins dans certains domaines et qui s'étend d'un moyen de connexion électrique (15) à une surface d'élément détecteur (14), sachant que le corps présente plusieurs domaines, où un domaine conducteur (13) est tout à fait électriquement conductible entre le moyen de connexion électrique (15) et la surface d'élément détecteur (14), sachant qu'un domaine isolant (17) ne présente pas de conductivité électrique et qu'on trouve au moins un domaine isolant (17) entre plusieurs domaines conductibles (13), sachant que les domaines conductibles (13) et le ou les domaines isolants (17) sont raccordés d'une seule pièce entre eux,
**caractérisé en ce que**
le corps (11) est muni d'un revêtement isolant à la face orientée vers le moyen de connexion électrique (32), sachant que le moyen de connexion électrique présente des fiches oblongues et élevées, qui pénètrent à travers le domaine isolant dans le domaine conductible pour réaliser la connexion électrique.

2. Dispositif d'élément détecteur d'après la revendication 1, **caractérisé en ce que** la surface d'élément détecteur (14) est constituée par la surface d'une partie d'un domaine conductible (13), sachant que la surface d'élément détecteur est constituée par la surface de contact entre une partie d'un domaine conductible et un recouvrement (40) auquel le dispositif d'élément détecteur (11) est adjacent.

3. Dispositif d'élément détecteur d'après une des revendications précédentes, **caractérisé en ce que** dans la direction d'étendue à partir du moyen de connexion électrique (15) vers la surface d'élément détecteur (14) au moins les domaines conductibles (13) s'étendent à peu près dans la même direction, de préférence parallèlement, sachant notamment que également les domaines isolants (17) s'étendent dans cette direction et que les domaines présentent une forme cylindrique.

4. Dispositif d'élément détecteur d'après une des revendications précédentes, **caractérisé en ce que** les domaines (13, 17) présentent une forme allongée dans cette direction d'étendue, sachant qu'ils présentent de préférence une dimension plus prononcée en direction d'étendue que dans une autre direction transversale.

5. Dispositif d'élément détecteur d'après une des revendications précédentes, **caractérisé en ce que** le corps (11) est composé d'un matériau genre caoutchouc, qui est rendu électriquement conductible notamment par des incorporations.

6. Dispositif d'élément détecteur d'après une des revendications précédentes, **caractérisé en ce que** le corps (11) fait partie d'une barre, où la direction d'étendue des domaines (13, 17) est perpendiculaire par rapport à la direction longitudinale de la barre, sachant que notamment la barre est rectiligne à l'origine, de préférence en direction longitudinale, et qu'elle peut être pliée dans une direction transversale par rapport à la direction d'étendue des domaines.

7. Dispositif d'élément détecteur d'après une des revendications précédentes, **caractérisé en ce que** les domaines forment ensemble un corps reparti par champs, s'étendant sous forme aplatie en direction orthogonale par rapport à la direction d'étendue, sachant que des domaines conductibles (13) et isolants (17) sont disposés tour à tour dans les deux directions d'étendue du corps et que de préférence les domaines conductibles (13) sont séparés entre eux dans chaque direction.

8. Dispositif d'élément détecteur d'après la revendication 7, **caractérisé en ce qu'**un domaine isolant (17) ou un espace d'air se trouvent dans la ligne directe entre deux domaines conductibles (13) limitrophes.

9. Dispositif d'élément détecteur d'après une des revendications précédentes, **caractérisé par le fait que** le corps peut être découpé ou que deux domaines peuvent être séparés à des points de raccordement, cette séparation étant opérable de préférence par étirage ou déchirage manuel sans autres moyens.

10. Dispositif d'élément détecteur d'après une des revendications précédentes, **caractérisé en ce que** le moyen de connexion électrique présente des contacts (32), où les contacts (32) présentent notamment au moins un écart correspondant à la distance entre deux domaines conductibles (13) et sachant que l'on prévoit de préférence plusieurs domaines conductibles (13) entre deux contacts (32) limitrophes.

11. Dispositif d'élément détecteur d'après une des revendications précédentes, **caractérisé en ce qu'**un domaine isolant (17) forme un diélectrique entre deux domaines conductibles (13), de manière à réaliser des capacités transversales (Cₚ) ou encore connexions capacitives entre les domaines conductibles.

12. Dispositif d'élément détecteur d'après une des revendications précédentes, **caractérisé en ce qu'**un domaine conductible (13) est entièrement gainé d'un ou de plusieurs domaines isolants (17) en direction latérale, transversalement par rapport à sa direction d'étendue.
